# EUROPEAN PATENT APPLICATION

(11) **EP 1 967 317 A1**
(43) Date of publication of application: **10.09.2008**
(21) Application number: 08101344.3
(22) Date of filing: 06.02.2008
(51) Int. Cl.: B23K 26/38

(54) **Method for separating a workpiece and laser processing apparatus**

(30) Priority: 07.03.2007 JP 2007057860
(71) Applicant: FUJITSU LIMITED, Kawasaki-shi, Kanagawa 211-8588 (JP)
(72) Inventor: Tokura, Fumihiko, Kawasaki-shi Kagawa 211-8588 (JP)
(74) Representative: Seeger, Wolfgang

(57) **Abstract**

According to an aspect of an embodiment, a method for fabricating a workpiece comprises the steps of: irradiating the workpiece with a laser light to raise a temperature of the workpiece at an elevated level under which at least a part of the workpiece is melted, and maintaining at least a part of the workpiece to be melted until the part of the workpiece is separated.

## Description

### BACKGROUND OF THE INVENTION

The present invention relates to a method of fabricating a workpiece, such as Micro Electro Mechanical Systems (MEMS).

### SUMMARY

According to an aspect of an embodiment, a method for fabricating a workpiece comprises the steps of: irradiating the workpiece with a laser light to raise a temperature of the workpiece at an elevated level under which at least a part of the workpiece is melted, and maintaining at least a part of the workpiece to be melted until the part of the workpiece is separated.

### BRIEF DESCRIPTION OF THE DRAWINGS

FIG. 1 is a block diagram schematically showing the structure of an exemplary laser processing apparatus according to the present invention.
FIG. 2 is a partially enlarged plan view schematically showing the structure of a fine workpiece.
FIG. 3 is a partially enlarged perspective view schematically showing the state in which a temporary retainer is irradiated with a laser beam.
FIG. 4 is a graph showing the relationship among an irradiation time of a laser beam, a temperature of a fine workpiece, and an output of the laser beam, in the exemplary laser processing apparatus according to the present invention.
FIG. 5 is a partially enlarged perspective view schematically showing the state in which the temporary retainer is melted and separated.
FIGs. 6A to 6E are cross-sectional schematic views showing workpieces in an embodiment of the present invention.
FIG. 7 is a graph showing the relationship among an irradiation time of a laser beam, a temperature of a fine workpiece, and an output of the laser beam, in a laser processing apparatus according to a related art configuration.

### DESCRIPTION OF THE PREFERRED EMBODIMENTS

Optical switching elements are widely known. An optical switching element contains a mirror array. The mirror array contains a plurality of MEMS mirrors. The MEMS mirrors reflect light emitted from a plurality of input ports of optical fibers to a plurality of output ports of the optical fibers, thereby switching the path of optical signals.

In each MEMS mirror, the front side of a fixed electrode faces the back side of a movable electrode. The movable electrode has a mirror surface on the front side thereof. The movable electrode is coupled to a movable electrode substrate such that the posture of the movable electrode can be changed. The posture of the movable electrode, that is, the posture of the mirror surface is changed around predetermined X-and-Y-axes because of electrostatic attraction that is generated between the fixed electrode and the movable electrode.

The movable electrode has a fragile and fine structure. When the optical switch element is fabricated, it is desired to prevent the posture of the movable electrode from being changed during carriage of the mirror array. To prevent the posture from being changed, the movable electrode and the movable electrode substrate are fixed with a temporary retainer and inhibited from relatively moving. The temporary retainer is separate immediately before the assembly to the optical switching element.

To separate the temporary retainer, the temporary retainer is intermittently irradiated with, for example, a Q-switch oscillation pulse laser beam. The pulse width of the pulse laser beam is a value with microsecond. Such a pulse laser beam has a large output, and rapidly heats the temporary retainer. As a result, extremely small dusts scatter. If the dusts adhere on the mirror surface, the reflectivity of the mirror surface may deteriorate.

In addition, since the pulse laser beam has the large output, the pulse laser beam may apply an impact to the temporary retainer. The impact due to the irradiation causes the temporary retainer to be broken into small pieces. The small pieces scatter. If the scattering small pieces span the movable electrode and the movable electrode substrate, short circuit may occur between the movable electrode and the movable electrode substrate.

In light of the above situation, the present invention provides a method of fabricating a fine workpiece and a laser processing apparatus, both capable of preventing dusts from scattering, and preventing the fine workpiece from being broken into small pieces.

An embodiment of the present invention will be described below with reference to the attached drawings.

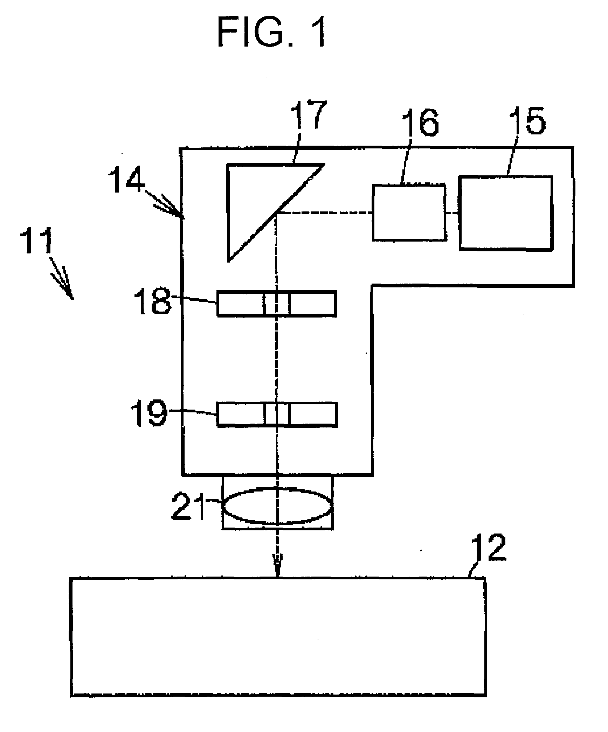

FIG. 1 schematically shows the structure of a laser processing apparatus 11 according to an exemplary embodiment of the present invention. The laser processing apparatus 11 has a stage 12. The stage 12 can move along a horizontal plane.

The stage 12 faces an optical system 14. The optical system 14 has an irradiation source, or a laser oscillator 15. The laser oscillator 15 outputs a continuous-wave green laser beam. The green laser beam has a wavelength of 532 nm as is known. The laser oscillator 15 uses a light-emitting diode (LED) as a light source. The laser oscillator 15 amplifies the light of the LED. The output of the green laser beam ranges, for example, from about 1.5 to about 2.4 W.

The laser oscillator 15 faces a collimator 16. The collimator 16 converts the green laser beam output from the laser oscillator 15 into parallel light. The collimator 16 faces a reflection mirror 17. The reflection mirror 17 reflects the laser beam output from the collimator 16 to a workpiece on the stage 12.

Two diaphragms 18 and 19 are disposed between the reflection mirror 17 and the stage 12. The diaphragms 18 and 19 control the light quantity of the laser beam. A lens 21 is disposed between the diaphragm 19 and the stage 12. The laser beam is emitted on the workpiece on the stage 12 and forms a predetermined spot with the lens 21.

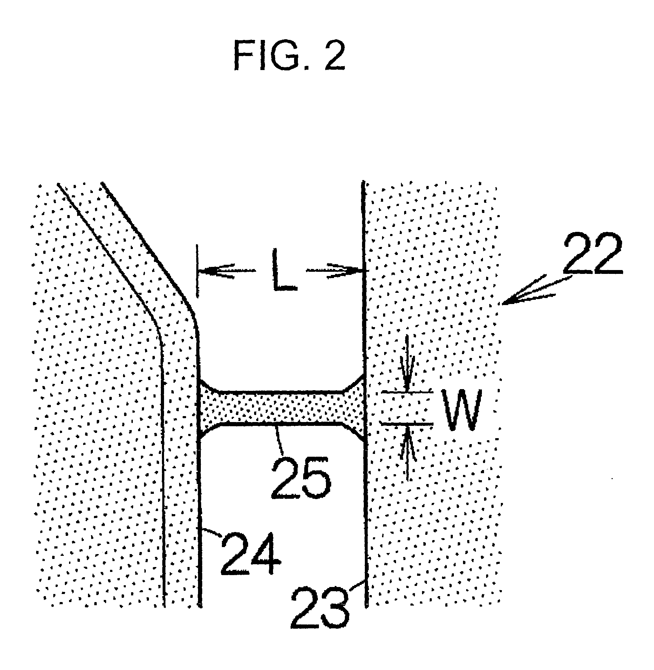

A method of fabricating a fine workpiece using the laser processing apparatus 11 is described. A workpiece 22 is placed on the stage 12. The workpiece 22 is a group of MEMS mirrors. As shown in FIG. 2, a temporary retainer 25 is formed between a movable electrode substrate 23 and a movable electrode 24, in each of the MEMS mirrors. A mirror surface is formed on the movable electrode 24. The temporary retainer 25 prevents the posture of the movable electrode 24 from being changed. The movable electrode substrate 23, the movable electrode 24, and the temporary retainer 25 are made by cutting silicon.

The width W of the temporary retainer 25 is, for example, about 5 µm. The length L of the temporary retainer 25 is, for example, about 10 µm. The thickness W of the temporary retainer 25 is, for example, about 10 µm. The optical axis of the optical system 14 is positioned at the center position of the temporary retainer 25 in accordance with horizontal movement of the stage 12. After the positioning, the laser oscillator 15 outputs the green laser beam. The output of the green laser beam is about 2.4 W.

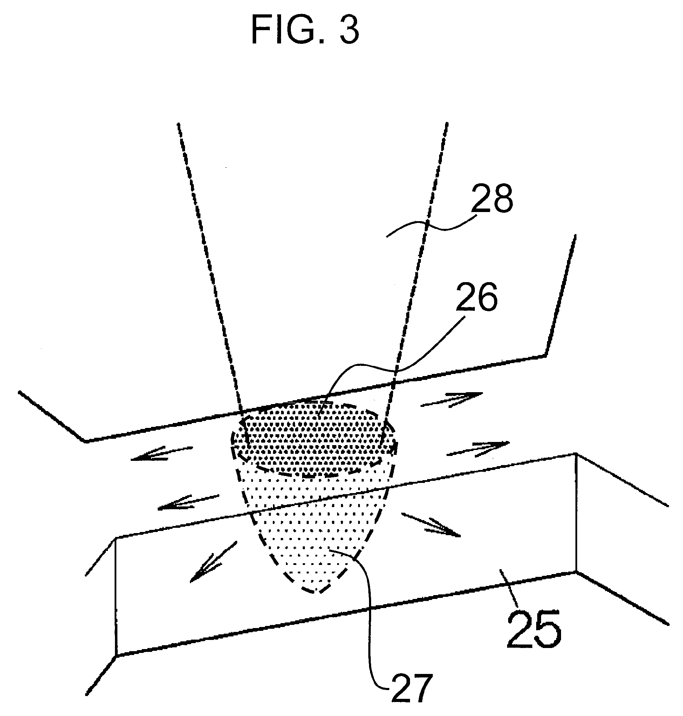

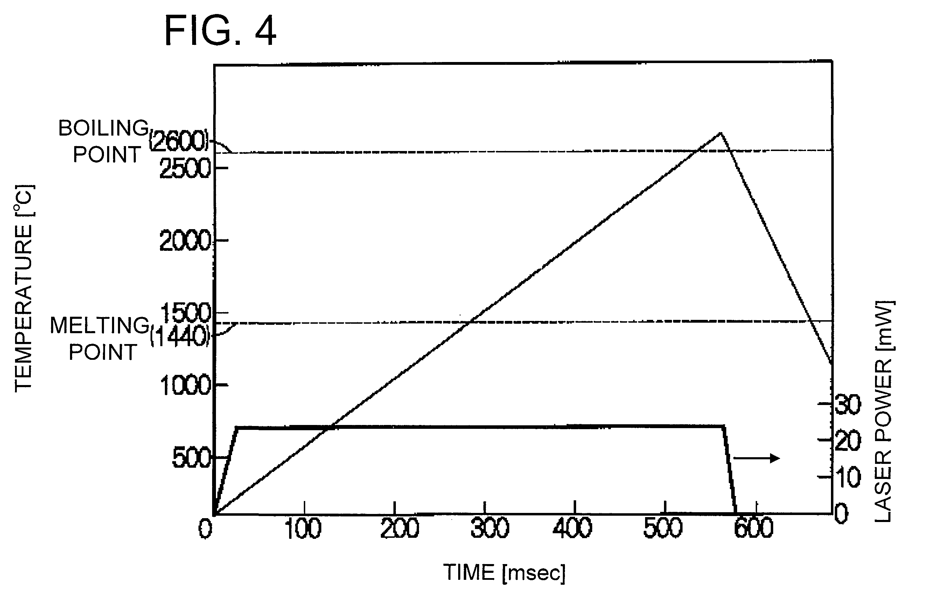

As shown in FIG. 3, the green laser beam 28 is irradiated on the temporary retainer 25, the green laser beam 28 producing a spot 26 of light at the temporary retainer 25. The size of the spot 26 is, for example, about 10 µm. Since the temporary retainer 25 is made of silicon, the temporary retainer 25 absorbs the green laser beam 28. Hence, the temporary retainer 25 is heated, and the temperature of the temporary retainer 25 increases. The heat is transmitted from the center position of the spot 26 to the entire area of the temporary retainer 25. A temperature-rise part 27 is heated. As shown in FIG. 4, the output of the green laser beam is held constant.

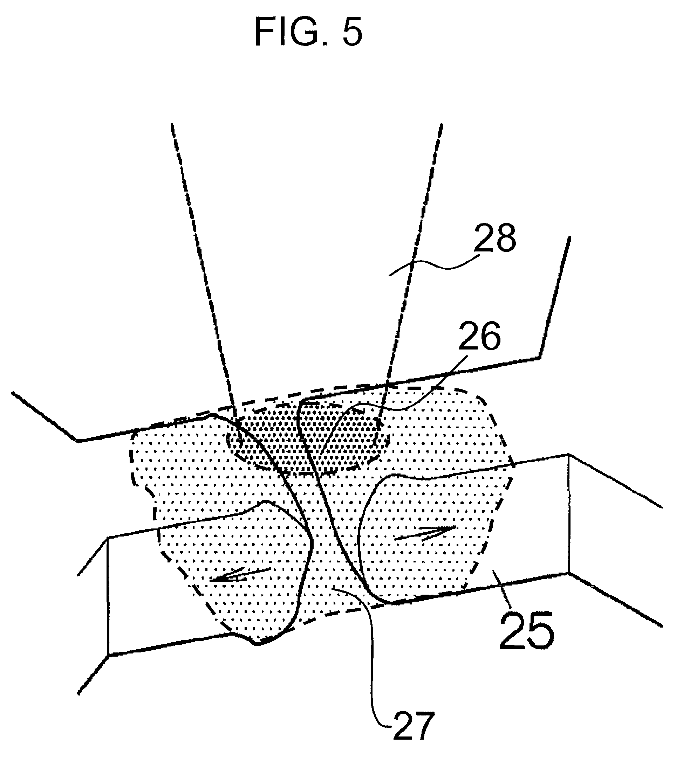

The irradiation with the green laser beam is continued until the temperature of the temperature-rise part 27 of the temporary retainer 25 exceeds the melting point and then reaches the boiling point of the silicon. Accordingly, as shown in FIG. 5, the temporary retainer 25 is melted and evaporated. Thus, a part of the temporary retainer 25 is melted and separated. The irradiation with the green laser beam 28 is stopped. The irradiation time of the green laser beam 28 is about 570 milliseconds. The temperature of the temporary retainer 25 decreases.

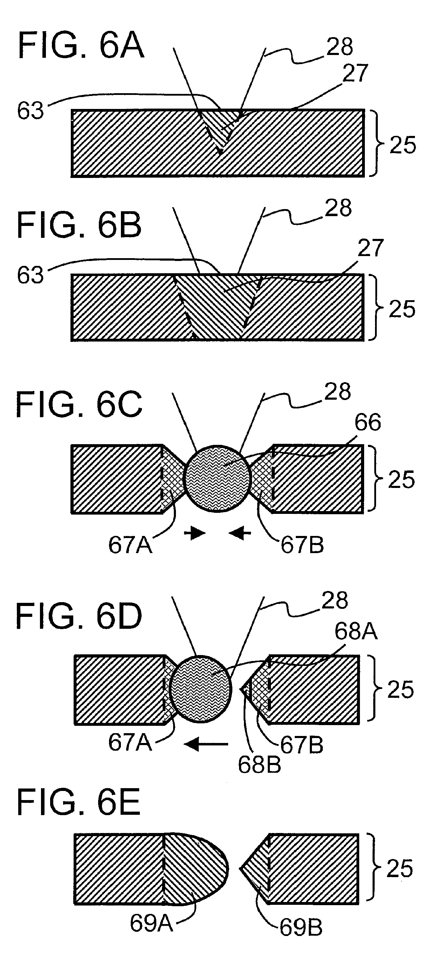

FIGs. 6A to 6E are cross-sectional schematic views showing workpieces in an embodiment of the present invention. As shown in FIG. 6A, a laser beam 28 is irradiated to a surface 63 of a temporary retainer 25. Then, temperatures on the surface 63 and a vicinity of the surface 63 begin to rise. Then, a temperature-rise part 27 in which the temperature is higher than the surrounding area is formed. The temperature-rise part 27 extends from the center position of the surface 63 to the entire area of the temporary retainer 25 as shown in FIG. 6B. Next, when the temperature of the temperature-rise part 27 exceeds a melting point, a part of the temperature-rise part 27 gathers in the center by surface tension thereof as shown in FIG. 6C. Then, a spherical part 66 that has fluidity is formed. Peripheries 67A and 67B of the spherical part 66 can respectively be constricted. Next, the spherical part 66 disrupts, and melting sections 68A and 68B are formed as shown in FIG. 6D. The ratio of the volumes of the melting section 68A and 68B depends on surface tension and gravity working at the spherical part 66, and interfacial tension between solid and liquid phases, and the like. At this time, the temporary retainer 25 is not boiling though it is melting and evaporating. After the temporary retainer 25 is separated, the irradiation of the green laser light 28 is stopped. After the irradiation, the melting sections 68A and 68B coagulate. Then, the melting section 68A integrates with the periphery 67A, the melting section 68A and the periphery 67A composing a transformed part 69A as a shown in FIG. 6E. Similarly, the melting section 68B integrates with the periphery 67B, the melting section 68B and the periphery 67B composing a transformed part 69B as shown in FIG. 6E.

After the temporary retainer 25 is separated, the irradiation is promptly stopped preferably because the temporary retainer 25 is prevented from boiling and another component around the temporary retainer 25 is prevented from overheating. Time from beginning the irradiation to the separation of the temporary retainer 25 can be examined beforehand so as to stop the irradiation promptly. The time can be assumed to be laser irradiation time. The method of examining the time is not especially limited. For instance, time until separating can be examined by preparing plural workpieces which are respectively irradiated in a variety of different time, taking images of temporary retainers of the workpieces, and judging whether the temporary retainers are respectively separated or not.

Then, the stage 12 horizontally moves. The optical axis of the optical system 14 moves to a next temporary retainer 25 by the movement of the stage 12. The temporary retainer 25 is melted and separated in a manner similar to the above. In this way, temporary retainers 25 are melted and separated for all MEMS mirrors. The MEMS mirrors are assembled to a mirror array. The mirror array is assembled to an optical switching element. The optical switching element is thus fabricated.

With such a method of fabricating a fine workpiece, the temporary retainer 25 is continuously irradiated with the continuous-wave green laser beam during a time period from the beginning of the irradiation to the melting and separating. The temporary retainer 25 sufficiently absorbs the green laser beam. As a result, the temperature of the temporary retainer 25 gradually increases. The temperature of the temporary retainer 25 can be prevented from being rapidly changed. Thus, dusts can be prevented from being generated at the temporary retainer 25. The dusts can be reliably prevented from scattering. In addition, since no impact is applied to the temporary retainer 25, the temporary retainer 25 can be prevented from being broken into small pieces. The small pieces can be reliably prevented from scattering.

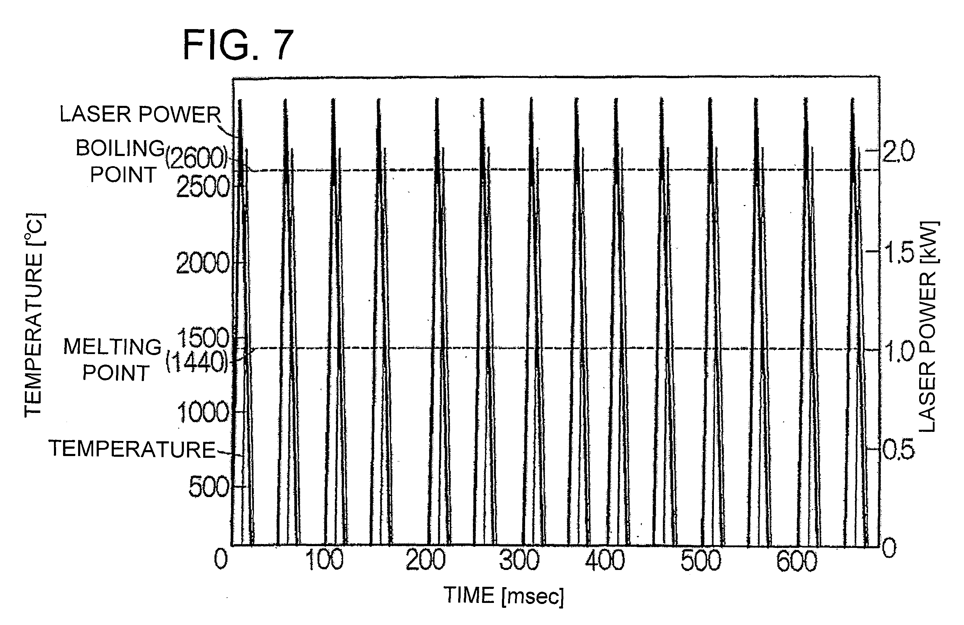

In contrast, with the related art configuration, for example, a Q-switch oscillation pulse laser beam having, for example, a pulse width with microsecond is emitted. The pulse laser beam has an oscillation frequency with kHz. As shown in FIG. 7, the laser beam is intermittently emitted. The laser beam has a high output of, for example, several kW. The temperature of a temporary retainer rapidly increases every time when being irradiated with the laser beam. Dusts may be generated at the temporary retainer because of the change in temperature. In addition, an impact may be applied to the temporary retainer because of the irradiation with the laser beam. The temporary retainer may be broken into small pieces.

The laser processing apparatus 11 may use a quasi-continuous-wave laser beam instead of the above-described green laser beam. The pulse width of the quasi-continuous wave is a smaller value than the pulse width of the above-mentioned pulse wave as is known. The pulse width is, for example, several tens of ps. The laser oscillation is several tens of MHz. The peak energy is several hundreds of W. In addition, the output of the quasi-continuous wave can be reduced as compared with the above-mentioned pulse wave. That is, the laser beam forms a continuous wave in a quasi manner. Alternatively, for example, a pulse-wave laser beam having a pulse width of 1 millisecond or greater may be used. The laser beam of such pulse wave may have a pulse width that is greater than the irradiation time from the beginning of the irradiation to the melting and separating.

The above-mentioned embodiment can provide the method of fabricating the fine workpiece, and the laser processing apparatus, both capable of preventing the dusts from scattering and preventing the fine workpiece from being broken into small pieces.

## Claims

1. A method for fabricating a workpiece comprising the step of:
irradiating the workpiece with a laser light to raise a temperature of the workpiece at an elevated level under which at least a part of the workpiece is melted, and
maintaining at least a part of the workpiece to be melted until the part of the workpiece is separated.

2. The method according to claim 1, wherein the laser light is a continuous-wave laser light.

3. The method according to claim 1, wherein the laser light is a pulse-wave laser light having a pulse width equal to 1 millisecond or greater, and the pulse width is equal to or greater than a time of irradiating the workpiece.

4. The method according to claim 1, wherein the laser light is a quasi-continuous-wave laser light.

5. The method according to claim 1, wherein the workpiece comprises silicon.

6. The method according to claim 1, wherein the temperature of the workpiece keeps rising continuously until the part of the workpiece is separated.

7. The method according to claim 1, wherein the laser light is irradiated so that the temperature should not fall until the part of the workpiece is separated.

8. A method for fabricating a workpiece comprising the step of:
irradiating the workpiece with a continuous-wave laser light continuously until a part of the workpiece is separated.

9. A method for fabricating a workpiece comprising the step of:
irradiating the workpiece with a quasi-continuous-wave laser light continuously until a part of the workpiece is separated.

10. A laser processing apparatus for fabricating a workpiece comprising:
a stage for disposing the workpiece;
an irradiation source for irradiating the workpiece with a laser light to raise a temperature of the workpiece at an elevated level under which at least a part of the workpiece is melted, and maintaining at least a part of the workpiece to be melted until the part of the workpiece is separated.

11. The laser processing apparatus according to claim 10, wherein the laser light is a continuous-wave laser light.

12. The laser processing apparatus according to claim 10, wherein the laser light is a pulse-wave laser light having a pulse width equal to 1 millisecond or greater, and the pulse width is equal to or greater than a time of irradiating the workpiece.

13. The laser processing apparatus according to claim 10, wherein the laser light is a quasi-continuous-wave laser light.

14. The laser processing apparatus according to claim 10, wherein the temperature of the workpiece keeps rising continuously until the part of the workpiece is separated.

15. The laser processing apparatus according to claim 10, wherein the laser light is irradiated so that the temperature should not fall.

16. A laser processing apparatus for fabricating a workpiece comprising:
a stage for disposing the workpiece;
an irradiation source for irradiating the workpiece with a continuous-wave laser light continuously until a part of the workpiece is separated.
